# EUROPEAN PATENT APPLICATION

(11) **EP 2 367 215 A1**
(43) Date of publication of application: **21.09.2011**
(21) Application number: 10002693.9
(22) Date of filing: 15.03.2010
(51) Int. Cl.: H01L 51/50

(54) **An organic photoactive device**

(71) Applicant: Novaled AG, 01307 Dresden (DE)
(72) Inventor: Dr. Lessmann Rudolf, 01307 Dresden (DE); Dr.Werner Ansgar, 01277 Dresden (DE); Rothe Carsten, 01326 Dresden (DE)
(74) Representative: Bittner, Thomas L.

(57) **Abstract**

The invention relates to an organic photoactive device provided with a first electrode, a second electrode, and a stack of organic layers provided between the first and second electrodes, the stack of organic layers comprising: a first transport layer provided as a layer transporting charge carriers of a first type, a second transport layer provided as a layer transporting charge carriers of the first type, an interface mediating layer provided in between and in contact with the first and second transport layers, and a photoactive layer, wherein the interface mediating layer is made of a first organic material, and at least one of the first and second transport layers comprises a second organic material, the first and second organic materials being selected to form a dopant-host material system for electrical doping, and wherein conditions for energetic levels of the first and second transport layers are defined depending on the type of charge carrier.

## Description

The invention relates to an organic photoactive device.

### Background of the invention

Organic photoactive devices, also known as organic optoelectronic devices, are known in scv-eral different configurations. Typical examples are organic light emitting diodes (OLEDs), organic photodetectors, organic solar cells, and others. These devices are fabricated with so called conjugated organic compounds, which comprise small molecules, polymers, den-drimers, and others. These devices are typically multilayer devices, which optionally also comprises inorganic layers. The multilayer structure is usually sandwiched between two electrodes, which are conductive. Such devices are disclosed for example in US 7,355,197, US 2009/212280, US 2009/235971, and US 2009/217980.

It has been object of intensive research to improve the lifetime of organic electronic photoactive devices. Organic electronic devices need to be encapsulated in an ambient without any radical chemical compounds which could react with the organic semiconductors. Typically, the organic semiconductors need to be isolated from water and oxygen. This requirement is especially true for photoactive devices, in which chemical reactions are easily photo-induced. Therefore, those devices are encapsulated in between two physical barriers, typically one is the substrate such as glass or metal and the other is a glass cover, but other configurations are also available, e.g. such as flexible multilayer barriers. A getter material is used inside the encapsulation; the getter has the function to absorb eventual water and oxygen molecules.

Nevertheless, residual water still account for considerable degradation of the organic semiconducting material. For example, the well known Alq₃ is not stable in an oxidized state (e.g. by transporting holes) because it reacts with water impurities. This kind of analysis led to a careful selection of the hole and electron transport materials, which must show highest stability under operating conditions.

Electrodes need to be as well protected from the ambient. For instance the surface of the common Aluminum cathode is highly reactive and can be damaged in presence of contaminants such as water and oxygen. Such reactions are one of the causes of the "dark spots". A good encapsulation is essential to avoid such reactions. Electrodes are also chosen to provide a good injection of charge carriers into the respective HOMO or LUMO of the transport layers. A good injection is required; otherwise the high fields involved in a metal/semiconductor injection barrier or the energy wasted on the high voltages required for high brightness in OLEDs are detrimental for the lifetime. Also in solar cells, were the highest efficiency is crucial, any barrier needs to be avoided. Different techniques are used to improve injection, such as chemical modification of the electrodes surface, or the use of tunneling layers (injection layers). Another solution, which has several advantages, is to use doped organic semiconducting layers.

Hole transport layers (HTL) and electron transport layers (ETL) can be made more robust against degradation by using electrical doping. The electrical doping facilitates the tunneling of charge carriers through the barrier of the direct contacting transport layer and electrode generating an "ohmic contact". This improved contact is relatively stable against minor oxidation of the electrodes. Furthermore, the dopants provide a high conductivity in the transport layer, which conductivity is less sensible to the effect of deep traps caused by impurities or reacted species. Transport materials have been chosen to be reversible oxidized or reduced without chemical degradation. These materials also have to be stable against high energy photons, such as blue or even near UV light. Furthermore a thermal stability is of fundamental importance, since the morphology of the typically very thin layers should not change during the lifetime of the device.

The main efforts for increasing operational the stability of OLEDs are being made in the emitter layer (see e.g. US 2008/203406). A high charge to photon conversion efficiency ensures that no energy is wasted, providing a higher efficiency. The wasted energy is transformed into heat, and it is known that most of the chemical degradation pathways are thermally activated. A high efficiency ensures lowest operating voltage and current, and consequently, lowest op-crating temperature. Additionally, triplet emitters were developed to increase the efficiency; however a stable and efficient blue triplet emitter is not yet available. Other improvements in the emission layer arc the addition of stabilizers, to chemically stabilise the emitter host and dopant materials.

### Summary of the invention

It is the object of the invention to provide an improved organic photoactive device.

A further object is to improve the lifetime of an organic light emitting device, especially to stabilize the operational voltage. Another object is to improve the fill factor of an organic solar cell, and also to stabilize the fill factor and the efficiency of a solar cell over its lifetime. Another object is to improve the fill factor, the overall efficiency and also the lifetime of organic solar cells with negative barriers between two transport layers.

The object is solved by an organic photoactive device according claim 1. Advantageous developments of the invention are disclosed in dependent claims.

It is an advantage of the device proposed that it has an increased operation lifetime compared to the prior art. Even if all the measures of the prior art are taken into consideration, there is still a degradation at the internal energy barriers which increases operation voltage, conse-qucntly decreasing the lifetime. Using an interface mediating layer (IL), this interface is stabilized and a longer operational lifetime is achieved. The advantages are achieved by employing the interface mediating layer between two not electrically doped charge carrier transport layers, where one type of charge carrier has to be transported through. Surprisingly, the advantages are also achieved when one or both of the charge carrier transport layers are doped. In a preferred embodiment, the interface mediating layer is provided between a charge carrier transporting heterointerface with a difference of transport energy levels (HOMO/HOMO or LUMO/LUMO) of ±0.7 eV.

It has been found that energetic barriers are one of the causes for degradation in multilaycred optoelectronic organic devices. Charge carriers do accumulate at the interfaces due to the en-ergy barriers, which arc typically much higher (at least 3 x) than the thermal energy (~30 meV) at typical operating conditions (25 to 80 °C). The accumulation of charge carriers can also be described as an increase in charged molecules at the interface. Charged molecules have inherently a lower stability which increases the probability for chemical reactions or fragmentation. It was found that these interfaces are critical in doped as well as non doped interfaces. However the doped/non doped and especially non-doped/non-doped interfaces are even more critical. The term doping refers to electrical doping of an organic semiconductor matrix material. Energetic barriers between layers of different materials cannot be avoided and are sometimes even require in organic electronic devices. For example, especial minority charge carrier blocking layers are used in an OLED to confine the injected charges into the recombination zone to increase the recombination and consequently the emission efficiency. Also in multilayer organic solar cells, such blocking layers can be employed, where they work as a filter, so that only one type of charge carrier can exit the absorbing layer towards the respective electrode. Such a blocking layer must have its conduction and valence energy levels tailored, in such a way that it works as a blocking layer for one type of charge carrier type but, at the same time, docs not inhibit the transport of the other charge carrier type. Such kinds of blocking layers, and the requirements for their energy levels, are described in the patent US 7,074,500. Other energetic barriers can appear when, for example, transport layers or blocking layers contact the emitter layer. Other examples arc the direct contact between two transport layers of the same type, for example HTL/HTL interfaces, or EBL/HTL interfaces. The energetic barriers arc always related to the majority charge carriers.

In case of solar cells, the operating voltage is the voltage at the maximum power point, which drops during its lifetime. The drop in voltage is expressed by a drop of the fill factor (FF) which is directly related to the power efficiency. Employing the interface mediating layer it is possible to minimize the effect of the efficiency loss upon aging.

The interface mediating layer made of a dopant material increases the charge density at an interface between two layers improving the charge transfer through the interface. The interfaces is preferentially a heterointerface, namely an interface between two layers of different materials. The charge carrier transport is kept transport limited (contrary to injection limited), and therefore there is a lower voltage increase during operation. Additionally there is also a lower initial driving voltage.

The interface mediating layer is preferentially used between a helerointerface with a positive barrier between 0.1 cV and 1 eV. A positive energy barrier is a barrier which needs to be overcome. A positive barrier for holes is if a hole in a first HOMO level must be transported to a second HOMO level which is more negative than the first HOMO level. A positive barrier for electrons is if an electron in a first LUMO level must be transported to a second LUMO level which is more positive than the first LUMO level. A negative barrier is for a hole in a HOMO1 is a HOMO2 where HOMO2<HOMO1. A negative barrier is for an electron in a LUMO1 is a LUMO2 where LUMO2>LUMO1.

It has been found that the mobility also plays an important role for the charge carrier accumulation at positive barriers. In one possible embodiment, at least one of the layers of the heterointerface is provided with a charge carrier mobility, for the majority type charge carrier, smaller than 10⁻⁴ cm²/Vs. More preferably, the difference of the charge carrier mobility, for the majority type charge carrier between the two layers is bigger than a factor 10. Even more preferably, the difference of the charge carrier mobility, for the majority type charge carrier between the two layers is bigger than a factor 100 (a practical limit for the difference is a factor 10⁸).

In a preferred embodiment, at least one of the first and second transport layers is provided with a layer thickness of at least about 20 nm.

According to a further embodiment, the photoactive layer is provided in the second transport layer or separately from the first and second transport layers. The photoactive layer may also be referred to as opto-electronic layer. In OLEDs the photoactive layer is the emitter layer (which can comprise sublayers), and in solar cells it is the absorption layer (which can also comprise sublayers).

In still a further embodiment, the interface mediating layer is provided with a layer thickness of 0.3 nm to 4 nm, preferentially of 0.3 nm to 2 nm.

According to a preferred embodiment, at least one of the first and second transport layers is provided as an electrically doped transport layer comprising a mixture of the first and second organic material, the first and second organic materials being provided as an electrical dopant material and a matrix material, respectively. In case the dopants are precursors to radical species, then HOMO and LUMO are effective values determined from doping experiments. For instance, if an n-dopant can doped a matrix with LUMO as positive as -4.0 cV then the effective HOMO of the n-dopant is approximately equal in to the value of -4.0 eV. If a p-dopant can doped a matrix with HOMO as negative as -4.8 eV then the effective LUMO of the n-dopant is approximately equal to the value of -4.8 eV. These values of -4 eV and -4.8 eV are extreme values, usually the LUMO of C60 is the lowest (more negative) useful LUMO for a solar cell. For an OLED the LUMO is typically higher (more positive) than -3 cV.

In another preferred embodiment, one of the following features is provided: if the electrically doped transport layer is a hole transport layer, the energetic HOMO level of the matrix material (HOMO_matrix) and the energetic LUMO level of the dopant material (LUMO_dopant) are provided as follows: LUMO_dopant < HOMO_matrix + 0.5 eV, preferably LUMO_dopant < HOMO_matrix + 0.3 eV, and if the electrically doped transport layer is an electron transport layer, the energetic LUMO level of the matrix material (LUMO_matrix) and the energetic HOMO level of the dopant material(HOMO_dopant) arc provided as follows: LUMO_matrix - 0.5 eV < HOMO_dopant, preferably LUMO_matrix 0.5 eV < HOMO_dopant. Preferrably, the transport layer located closer to the photoactive layer is provided as non-doped transport layer.

It is further preferred that if the electrically doped transport layer is a hole transport layer, the energetic HOMO level of the matrix material (HOMO_matrix) and the energetic LUMO level of the dopant material (LUMO_dopant) arc provided as follows: HOMO_matrix - 0.5 cV < LUMO_dopant < HOMO_matrix + 0.5 eV, preferably HOMO_matrix - 0.5 cV < LUMO_dopant < HOMO_matrix + 0.3 eV, and if the electrically doped transport layer is an electron transport layer, the energetic LUMO level of the matrix material (LUMO_matrix) and the energetic HOMO level of the dopant material(HOMO_dopant) are provided as follows: LUMO_matrix - 0.5 eV < HOMO_dopant < LUMO_matrix + 0.5 eV, preferably LUMO_matrix - 0.5 eV < HOMO_dopant < LUMO_matrix + 0.3 eV. Preferrably, the transport layer located closer to the photoactive layer is provided as non-doped transport layer.

In a preferred embodiment, at least one of the first and second transport layers is provided as an electrically non-doped transport layer.

According to a further embodiment, the photoactive layer is provided with a plurality of photoactive sub-layers.

In still a further embodiment, the first and second transport layers comprise different organic materials.

According to a preferred embodiment, the photoactive layer comprises a light emitting layer provided in an organic light emitting diode.

In another preferred embodiment, the following features are provided:
- the second transport layer is closer to the light emitting layer than the first transport layer,
- the charge carriers of the first type are injected from the first transport layer into the second transport layer, and
- one of the following features is provided:
   - if the charge carriers of the first type are holes, the energetic HOMO level of the first transport layer (HOMO_1) and the energetic HOMO level of the second transport layer (HOMO_2) are provided as follows: HOMO_2 - 0.2 eV < HOMO_1 < HOMO_2 + 0.5 eV and HOMO_1 ≠ HOMO_2, and
   - if the charge carriers of the first type are electrons, the energetic LUMO level of the first transport layer (LUMO-1) and the energetic LUMO level of the second transport layer (LUMO_2) are provided as follows: LUMO_2 - 0.5 cV < LUMO_1 < LUMO_2 + 0.2 eV and LUMO_1 ≠ LUMO_2.

The invention shows the greatest improvements when the barriers are positive, even better if they arc positive and greater than 0.1 cV (as absolute value).

In a preferred embodiment, one of the following features is provided:
- if the charge carriers of the first type arc holes, the energetic HOMO level of the first transport layer (HOMO_1) and the energetic HOMO level of the second transport layer (HOMO_2) are provided as follows: HOMO_1 > HOMO_2 - 0.1 eV, and
- if the charge carriers of the first type are electrons, the energetic LUMO level of the first transport layer (LUMO_1) and the energetic LUMO level of the second transport layer (LUMO_2) are provided as follows: LUMO_2 - 0.1 eV > LUMO_1.

According to a further embodiment, the photoactive layer comprises a light absorbing layer provided in an organic solar cell.

In still a further embodiment, the following features are provided:
- the second transport layer is closer to the light absorbing layer than the first transport layer,
- the charge carriers of the second type arc injected from the first transport layer into the first transport layer, and
- one of the following features is provided:
   - if the charge carriers of the first type are holes, the energetic (HOMO level of the first transport layer (HOMO_1) and the energetic HOMO level of the second transport layer (HOMO_2) are provided as follows: HOMO_2 - 0.2 eV < HOMO_1 < HOMO_2 + 0.5 eV and HOMO_1 ≠ HOMO_2, and
   - if the charge carriers of the first type are electrons, the energetic LUMO level of the first transport layer (LUMO_1) and the energetic LUMO level of the second transport layer (LUMO_2) are provided as follows: LUMO_2 - 0.5 eV < LUMO_1 < LUMO_2 + 0.2 eV and LUMO_1 ≠ LUMO_2.

The first and second transport layers may be made of different materials. The first and second transport layers each may comprise a different material as their essential material (concentration over 50%, preferentially over 80%). The first transport layer comprises a material in a concentration over 50% which is different than the material of the second layer which material of the second layer is also in a concentration over 50%.

In a further embodiment, the following features are provided:
- the photoactive layer is provided as a light emitting layer,
- the second transport layer is closer to the light emitting layer than to the first transport layer,
- charge carriers of the first type arc injected from the first transport layer into the second transport layer,
- if the charge carriers of the first type are electrons follows:
   LUMO_2 - 0.5 eV <LUMO_1 <LUMO_2 + 0.2 eV and LUMO_1 ≠ LUMO_2, and
- if the charge carriers of the first type are holes follows:
   HOMO_2 - 0.2 eV < HOMO_1 < HOMO_2 + 0.5 cV and HOMO_1 ≠ HOMO_2.

In still a further embodiment, if the charge carriers of the first type are holes it follows: LUMO_2 - 0.5 eV < LUMO_1, and HOMO_1 < HOMO_2 + 0.5 eV.

In a further embodiment, the following features are provided:
- the photoactive layer is provided as a light absorbing layer,
- the second transport layer is closer to the light absorbing layer than to the first transport layer,
- charge carriers of the first type are injected from the second transport layer into the first transport layer,
- if the charge carriers of the first type are electrons follows:
   LUMO_2 - 0.5 cV <LUMO_1 < LUMO 2 + 0.2 cV and LUMO_1 ≠ LUMO_2, and
- if the charge carriers of the first type are holes follows:
   HOMO_2 - 0.5 eV < HOMO_1 < HOMO_2 + 0.2 eV and HOMO_1 ≠ HOMO_2.

The relations above are especially valid if the charge carriers are the photogenerated charge carriers.

It was surprisingly found that the invention also improves heterointerfaces of two neighboring transport layers in organic solar cells for which the energy barrier of the transport level (HOMO or LUMO) for the photo generated charge carriers is negative.

Following, aspects of the electrically doping provided in some of the preferred embodiments are described in further detail.

By electrically doping hole transport layers with a suitable acceptor material (p-doping) or electron transport layers with a donor material (n-doping), respectively, the density of charge carriers in organic solids (and therefore the conductivity) can be increased substantially. Additionally, analogous to the experience with inorganic semiconductors, applications can be anticipated which are precisely based on the use of p- and n-doped layers in a component and otherwise would be not conceivable. The use of doped charge-carrier transport layers (p-doping of the hole transport layer by admixture of acceptor-like molecules, n-doping of the electron transport layer by admixture of donor-like molecules) in organic light-emitting diodes is described in US 2008/203406 and US 5,093,698.

The document US 2008/227979 discloses in detail the doping of organic transport materials, also called matrix, with inorganic and with organic dopants. Basically, an effective electronic transfer occurs from the dopant to the matrix increasing the Fermi level of the matrix. For an efficient transfer in a p-doping case, the LUMO energy level of the dopant must be more negative than the HOMO energy level of the matrix or at least slightly more positive, not more than 0.5 eV, to the HOMO energy level of the matrix. For the n-doping case, the HOMO energy level of the dopant must be more positive than the LUMO energy level of the matrix or at least slightly more negative, not lower than 0.5 eV, to the LUMO energy level of the matrix. It is furthermore desired that the energy level difference for energy transfer from dopant to matrix is smaller than + 0.3 eV.

The dopant donor is a molecule or a neutral radical or combination thereof with a HOMO energy level (ionization potential in solid state) more positive than -4.0 eV, preferably more positive than -3.3 eV. The HOMO of the donor can be estimated by cyclo-voltammetric measurements. An alternative way to measure the reduction potential is to measure the cation of the donor salt. For doped transport layers, the molar mass of the donor is in a range between 100 and 2000 g/mol, preferably in a range from 200 and 1000 g / mol. The molar doping concentration is in the range of 1:10000 (dopant molecule: matrix molecule) and 1:2, preferably between 1:100 and 1:5, more preferably between 1:100 and 1:10. The donor can be created by a precursor during the layer forming (deposition) process or during a subsequent process of layer formation (see DE 103 071 25). The above given value of the HOMO level of the donor refers to the resulting molecule or molecule radical.

A dopant acceptor is a molecule or a neutral radical or combination thereof with a LUMO level more negative than -4.5 eV, preferably more negative than -4.8 eV, more preferably more negative than -5.04 eV. The LUMO of the acceptor can be estimated by cyclo-voltammetric measurements. The acceptor has to exhibit a reduction potential that is larger than or equal to approximately -0.3 V vs Fc / Fc+ (Ferrum/Ferrocenium redox-pair), preferably larger than or equal to 0.0 V, preferably larger than or equal to 0.24 V. The molar mass of the acceptor is preferably in the range of 300 to 2000 g / mol, and even more preferably between 400 g/mol and 2000 g/mol. The molar doping concentration in doped layers is in the range of 1:10000 (dopant molecule : matrix molecule) and 1:5, preferably between 1:100 and 1:5, more preferably between 1:100 and 1:10. The acceptor can be created by a precursor during the layer forming (deposition) process or during a subsequent process of layer formation. The above given value of the LUMO level of the acceptor refers to the resulting molecule or molecule radical.

Typical examples of doped hole transport materials are: copperphthalocyanine (CuPc), which HOMO level is approximately -5.2 eV, doped with tetrafluoro-tetracyanoquinonedimethane (F4TCNQ), which LUMO level is about -5.2 cV; zinephthalocyanine (ZnPc) (HOMO = -5.2 eV) doped with F4TCNQ; a-NPD (N,N'-Bis(naphthalen-1-yl)-N,N'-bis(phenyl)-benzidine) doped with F4TCNQ.

Typical examples of doped electron transport materials are: fullerene C60 doped with acridine orange base (AOB); perylene-3,4,9,10-tetracarboxylic-3,4,9,10-dianhydride (PTCDA) doped with leuco crystal violet; 2,9 - di (phenanthren-9-yl) - 4,7 - diphenyl - 1,10 - phenanthroline doped with tetrakis (1,3,4,6,7,8 - hexahydro - 2H - pyrimido [ 1,2 - a] pyrimidinato) ditungsten (II) (W(hpp)₄); naphthalene tetracarboxylic acid di-anhydride (NTCDA) doped with 3,6-bis-(dimethyl amino)-acridine; NTCDA doped with bis(cthylcnc-dithio) tetrathiafulvalene (BEDT-TTF).

By using the term doping it is meant electrical doping as explained above. It is known that the doping increases the density of charge carriers of a semiconducting matrix towards the charge carrier density of the undoped matrix, An electrically doped semiconductor layer also has an increased effective mobility in comparison with the undoped semiconductor matrix. The dopants do not react chemically with the matrix materials (transport materials), meaning that dopants and matrix materials do not form pi or sigma bonds.

The p- or n-doping only delivers increased stability if the dopants do not diffuse, therefore, stable dopants with high molecular mass have to be used and small dopants such as e.g. metals, or salts which released metals have to be avoided.

The document DE 10 2004 010 954 discloses the use of electron-rich metal-complexes as donors for doping organic semiconductors. Electron-rich metal-complexes are for example Tetrakis ( 1,3,4,6,7,8 - hexahydro - 2H - pyrimido [1,2-a] pyrimidinato ) dichrom (II) or Tetrakis(1,2,3,3a,4,5,6,6a,7,8-decahydro-1,9,9b-triacaphenalenyl) ditungsten (II). Also, dopants from the document EP 2 002 492 are preferred.

Preferred n-dopants are: Cr₂hpp₄ (hpp: Anion von 1,3,4,6,7,8-Hexabydro-2H-pyrimido[1,2-a]pyrimidm) (D1); Fe₂hpp₄ (D2); Mn₂hpp₄ (D3); Co₂hpp₄ (D4); Mo₂hpp₄ (D5); W₂hpp₄ (D5); Ni₂hpp₄ (D6); Cu₂hpp₄ (D7); Zn₂hpp₄ (D8); W(hpp)₄ (D9); 4,4',5,5'-.Tetracyclohexyl-1,1',2,2',3,3' hexamcthyl-2,2',3,3'-tetrahydro-1H,1'H-2,2'-biimidazol (D10); 2,2'-diisopropyl-1,1',3,3'-tetramethyl-2,2',3,3',4,4',5,5',6,6',7,7'-dodecabydro-1H, 1'H- 2,2'- bibenzo [d] imida-zol (D11);2,2'-diisopropyl-4,4',5,5'-tetrakis(4-methoxyphenyl)-1,1',3,3'-tetramethyl
- 2,2',3,3' - tetrahydro - 1H.1'H - 2,2'- biimidazol (D12); 2,2'-Diisopropyl-4,5 - bis (2-methoxyphenyl) - 4',5'- bis (4 - methoxyphenyl) - 1,1',3,3' - tetramethyl-2,2',3,3' - tetrahydro
- 1H,1'H - 2,2' - biimidazol (D13); 1,1',2,2',3,3'-hexamethyl-4,4',5,5'-tetraphenyl-2,2',3,3'-tetrahydro-1H,1'H-2,2'-biiznidazole (D14); 2,2' - diisopropyl - 4,5 - bis(2-methoxyphenyl) - 4',5' - bis (3 - methoxyphenyl) - 1,1',3,3'- tetramethyl - 2,2',3,3' - tetrahydro - 1H,1'H-2,2' - biimidazol (D15). Preferred dopants arc those which do not comprise metal(s).

The document DE 103 57 044 describes the use of quinones and their derivatives as acceptors in organic semiconducting materials. Examples for acceptors are: 2,2,7,7-tetrafluoro-2,7-dihydro-1,3,6,8-dioxa-2,7-dibora-pentachloro-benzo[e]pyrene (A1), 1,4,5,8 - tetrahydro - 1,4,5,8 -tetrathia - 2,3,6,7 - tetracyanoanthrachinone (A2), or 1,3,4,5,7,8 - Hexafluoronaphtho - 2,6 - chinontetracyanomethane (A3). Preferred p-dopants are: 2,2' - (perfluornaphthalen - 2,6 -diyliden ) dimalononitril; 2,2' - (2,5 - dibrom - 3,6 - difluorcyclohexa - 2,5 - dien - 1,4 - diylidcn) dimalononitril; 2,2',2" - (cyclapropan - 1,2,3 - triyliden) tris (2 - (2,6 - dichlor-3,5 - difluor - 4 - (trifluormethyl) phenyl) acetonitril); 4,4',4"-cyclopropan-1,2,3-triylidentris(cyanomethan-1-yl-1-yliden)tris (2,3,5,6-tetrafluorbenzonitril). Other preferred dopants are disclosed in US 2008/265216.

Following, embodiments of the invention arc described in further detail.

The following abbreviations are used: AU -absorbing unit, ELU - electroluminescent unit, HJ - heterojunction in a solar cell, HTL - hole transport layer, ETL - electron transport layer, EML - light emitting layer in a light emitting diode, CRL - charge recombination layer, and CGL - charge generation layer.

Typical ELUs are composed of:
optional HTL / EML / ETL / interface mediating layer / ETL or
HTL / interface mediating layer / HTL / EML / optional ETL or
optional HTL / EML / ETL / interface mediating layer / ETL or
HTL / interface mediating layer / HTL / EML / optional ETL.

HTL and HTL can be provided with electrical doping. Additional layers are also possible. The transport layer adjacent to the EML is preferentially a thin interlayer (5-50 nm). The transport layer adjacent to the EML are more preferentially blocking layers:
optional HTL / EML / EBL / interface mediating layer / ETL or
HTL / interface mediating layer / EBL / EML / HBL / optional ETL or
optional HTL / EBL / EML / HBL / interface mediating layer / ETL or
HTL / interface mediating layer / EBL / EML / HBL / optional ETL.

Obviously more layers can be inserted such as cxciton blocking layer, injection layer, etc. Optionally the interface mediating layer can be in direct contact with the EML. This simplification is possible in some cases. However, preferentially, the EML is not in direct contact to the interface mediating layer.

Non stacked OLEDs comprise the typical structure anode / ELU / cathode. Stacked OLEDs comprise the typical structure anode / ELU / CGL / ELU / cathode. Additional layers arc also possible.

The same is valid for organic solar cells, in which case the absorbing layer is preferentially a hetero-junction. Typical HJ are flat heterojunctions or bulk-heterojunctions. Flat heterojunctions comprise at least two layers, where the energy levels of the at least two layer form an energy interface to separate the excitons. Preferentially the at least two layers form a staggered type II heterojunction. Examples of flat heterojunctions are ZnPc/C60 double layers. In the flat heterojunctions at least one of the layers comprises an absorbing material. The materials which are not absorbing must be good transporting materials. The absorbing materials are optionally good transporting materials, especially if the layers arc thicker than 5 nm. Bulk heterojunctions comprise normally one layer in which at least two materials are mixed, the energy levels of the at least two layer form an energy interface to separate the excitons. Graded or other layers are also possible, for example a HJ can be formed by a mixture between flat and bulk heterojunctionas in (Xue et al. Adv. Mat., V. 17, pp. 66-71, 2004).

The photoactive layer in a solar cell is defined as the layer in combination with a HJ which is responsible for the generation of excitons due to absorption of photons. This layer usually comprises a material which has an extinction coefficient > 1.10⁴ M⁻¹cm⁻¹ over a range of wavelengths of at least 100 nm which includes its absorption peak, where the peak is located in the range of 400 nm to 1200 nm.

Typical absorbing units (AU) are:
optional HTL / HJ / ETL / interface mediating layer / ETL or
HTL / interface mediating layer / HTL / HJ / optional ETL or
optional HTL / HJ / ETL / interface mediating layer / ETL or
HTL / interface mediating layer / HTL / HJ / optional ETL.

HTL and ETL can be electrically doped. Additional layers arc also possible. The transport layer adjacent to the HJ is preferentially a thin interlayer (5-50 nm). The transport layer adjacent to the HJ may be provided as a blocking layer:
optional HTL / HJ / EBL / interface mediating layer / ETL or
HTL / interface mediating layer / EBL / HJ / HBL / optional ETL or
optional HTL / EBL / HJ / HBL / interface mediating layer / ETL or
HTL / interface mediating layer / EBL / HJ / HBL / optional ETL.

In the solar cells, it is preferred that the interface mediating layer is not in contact with the HJ. A stacked organic solar cell may be provided with the following layers: cathode / HTL / HT / CRL / optionally doped HTL / interface intermediating layer / IL / HT / Anode.

### Description of preferred embodiments of the invention

Following the invention will be described in further detail, by way of example, with reference to different embodiments. In the figures show:
- Fig. 1: a schematic representation of an energy diagram for a light emitting organic diode comprising an interface mediating layer between two electron transport layers,
- Fig. 2: a schematic representation of an energy diagram for a light emitting organic diode comprising an interface mediating layer between two hole transport layers,
- Fig. 3: a schematic representation of an energy diagram for a light emitting organic diode comprising two interface mediating layers and
- Fig. 4: a schematic representation of an energy diagram for an organic solar cell comprising an interface mediating layer.

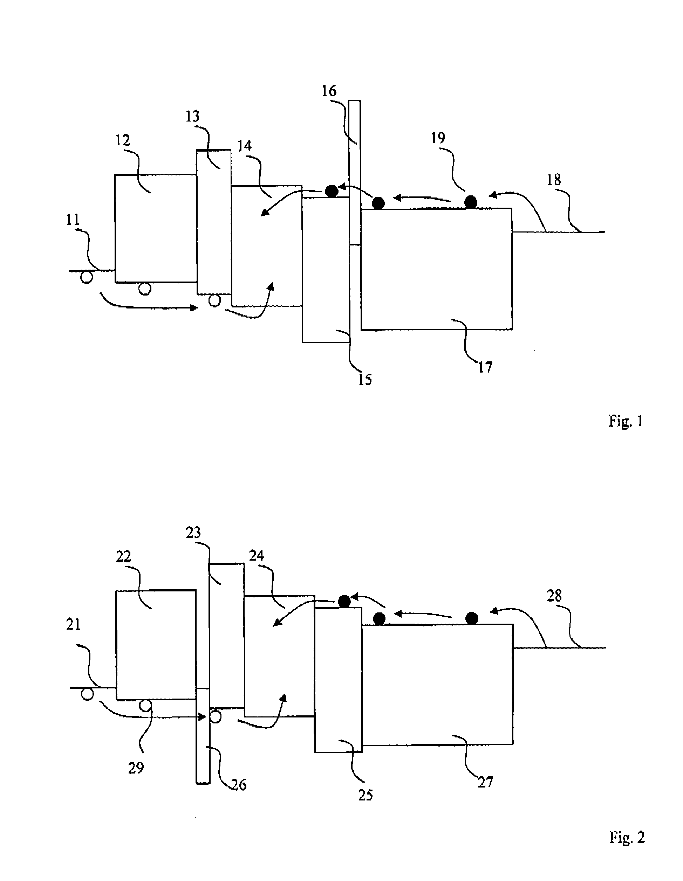

Fig. 1 shows one possible configuration of an OLED, a multilayer structure comprising an anode 11, a hole transport layer 12, an electron blocking layer 13 which is also a hole transporting layer, a light emitting layer 14, a hole blocking layer 15 which is also an electron transport layer, an electron transport layer 17, a cathode 18 and the interface mediating layer 16 between the two electron transporting layers 16 and 17. Holes (open circles) are injected from the anode 11 and electrons 19 are injected from the cathode 18 into the organic semiconducting layers. The holes and electrons recombine in the emitter layer 14 to emit light. The heterointerface between layers 15 and 17 is one of the possible sources for degradation of the device during operation. The interface mediating layer 16 has a high LUMO and protects the interface against degradation. Layers 13 is represented in the figure as a blocking layer, however it can also be a simple interlayer, without the blocking function.

Fig. 2 shows the energy diagram of an OLED with similar configuration to Fig. 1, except that an interface mediating layer is used at a heterointerface between two hole transport layers 22 and 23. Fig. 2 shows an anode 21 which inject holes 29 into the hole transport layer 22, which holes are transported to the light emitting layer 24 through the electron blocking layer 23. The electrons (closed circles) are injected from the cathode 28 in the electron transport layer 27 and transported to the light emitting layer 24 through the hole blocking layer 25. The interface mediating layer 26 has a low HOMO and protects the interface between layer 22 and 23 against degradation. Layers 23 is represented in the figure as a blocking layer, however it can also be a simple interlayer, without the blocking function.

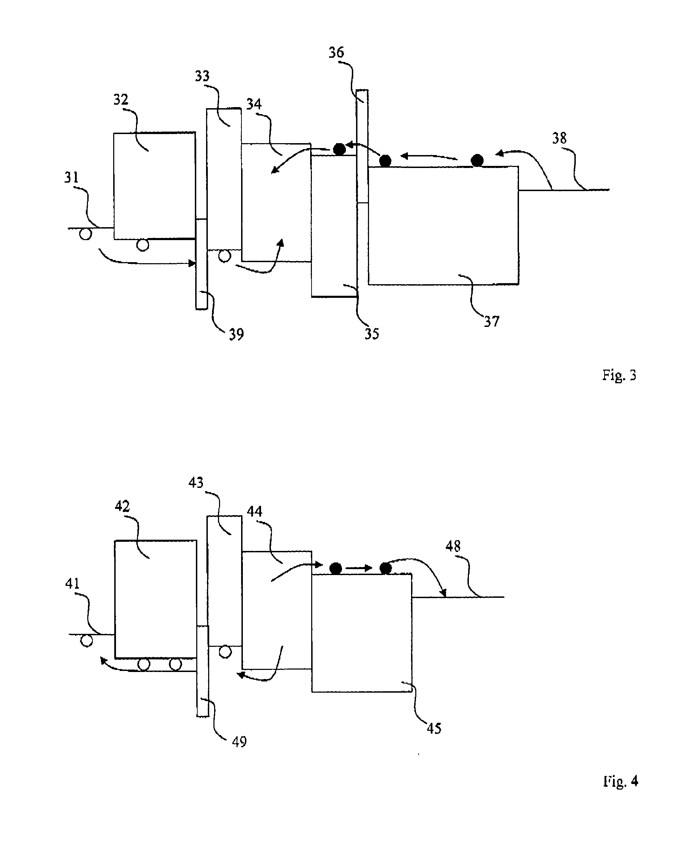

Fig. 3 is representing the energy diagram of an OLED comprising an interface mediating layer for holes 39 between the hole transport layer 32 and the electron blocking layer 33, and an interface mediating layer for electrons 36 between the electron transport layer 37 and the hole blocking layer 35. The holes arc injected from the anode 31 and the electrons are injected from the cathode 38, which holes and electrons recombine in the light emitting layer 34. Layers 35 and/or 33 are represented in the figure as blocking layers, however they can also be simple interlayers, without the blocking function.

Fig. 4 shows a multilayer organic solar cell with an interver p-i-n (n-i-p) structure. The solar cell comprises an anode 41, a hole transport layer 42, an electron blocking layer 43, a hetero-junction 44 which can be planar or bulk, a electron transport layer 45, a cathode 48 and an interface mediating layer 49 between hole transport layer 42 and electron blocking layer 43. The optically active layer 44 is a heterojunction of at least two materials which have a HOMO/LUMO separation big enough to separate the excitons generated by optical absorption in at least one of the materials. The charge carriers (electrons and holes) generated by separating the excitons are transported towards the HTL and ETL, the driving force is the diffusion and the difference of the quasi Fermi-levels in the HJ and the Fermi levels of the HTL and ETL. Doped HTL and doped ETL are preferred for high efficient devices. Layer 43 is represented in the figure as an electron blocking layer, however it can also be a simple interlayer, without the electron blocking function.

### Example 1.

### Example for the interface mediating layer (IL) on an electron transporting interface

The following layer sequence was used for comparative experiments:
Anode / p:HTL / EBL / blue emitting layer / 4-(naphthalen-1-yl)-2,7,9-triphenylpyrido[3,2-h]quinazoline / IL (2 nm) / n-ETL / Al

D 14 was used as IL.

| ETL: n-dopant | Vi→Vi₂(V) with IL | ΔVi ΔPcff % | ΔV without IL V | ΔV with IL V | ΔV with IL % |
|---|---|---|---|---|---|
| phenyldi(pyren-1-yl)phosphine axidc:D14 | 3.21 → 3.17 | 1,2 | +0,398 | +0,082 | 2,55% |
| 4,4'-bis(4,6-diphenyl-1,3,5-Gazin-2-yl)biphcnyl:D14 | 3.26 → 3.16 | 3,1 | +0,92 | -0,02 | -0,6% |
| tetrakis(2,3-dimethylquinoxalin-5-yloxy)zirconium:D14 | 3.51 → 3.39 | 3,5 | +0,983 | +0,054 | 1,5% |
| 2,2'-Bi(9,10-diphenyl-authracene):D10 | 3.20 → 3.18 | 1,0 | +1,33 | +0,44 | 13,8% |

The first column shows the matrix and the dopant used in the ETL. The second column (Vi → Vi₂(V)) shows the initial change of voltage of the OLEDs with IL. The voltage of the devices with IL is drastically lowered in the first hours of measurement, until a minimum (indicated on the right side of the arrow). The initial voltage also represents a gain in power efficicncy, shown as a percentage in the 3^{rd} column (Δ Peff). The fourth (ΔV without IL) and fifth columns (ΔV with IL) show the difference in voltage (initial voltage (Vi) - final voltage) respectively for devices without and with IL. The final voltage is the voltage necessary to drive the OLED at a constant current of 60 mA/cm² until the LT is reached (Life time is the time until 50% of initial luminance is reached). The last column to the right (ΔV without IL) shows the relative increase in %. The advantages of the IL can be clearly seen, the operating voltage of the OLED with IL is very stable over the whole lifetime. Also very high improvements were seen with non-doped ETL.

Such performance improvements were also observed for interlayers on the hole transporting side of the device.

### Example 2.

In the following examples it is shown that only a thin IL will significantly contribute to an improvement of the device.

The following layer sequence was used for comparative experiments:
Anode / p:HTL / 1;BL / blue emitting layer / 4-(naphthalen-1-yl)-2,7,9-triphenylpyrido[3,2-h]quinazoline HBL (10 nm) / Interface mediating layer / tetrakis(2,3-dimethylquinoxalin-5-yloxy)zirconiuzn doped with D14 / Al.

| Interface mediating layer (thickness nm) | V increase (%) at 60 mA/cm² |
|---|---|
| D14 (6 nm) | 7,17 |
| D14 (4 nm) | 2,79 |
| D14 (2 nm) | 0,91 |
| D14 (0 mn) | 23,7 |

The values for the voltage increase are a reference to the initial voltage.

### Example 3.

Another device was made using a commercial ETL1 doped with D9.

| ETL:n-dopant | Interface mediating layer (thickness nm) | V increase (%) at 60 mΛ/cm² |
|---|---|---|
| ETL1:D9 | D9 (6 nm) | 8,7 |
| ETL1 :D9 | D9 (4nm) | 7,11 |
| ETL1:D9 | D9 (2 nm) | 5,3 |
| ETL1:D9 | D9 (0 nm) | 14,31 |

### Example 4, organic solar cell with interface mediating layer

Two conventional m-i-p CuPc-C60 bulk heterojunction (BHJ) organic solar cells were fabricated by depositing the following layers on a glass substrate with patterned ITO:
1) 5 nm C60;
2) 35 nm C60:CuPc (weight ratio 2:1);
3) 10 nm N,N,N',N'-Tetrakis(4-methoxaphenyl)-benzidine;
4) interface mediating layer with the compound A3;
5) 40 nm N,N'-Diphenyl-NN'-bis(4'-(N,N-bis(naphth-1-yl)-amino)-biphenyl-4-yl)-benzidine doped with A3;
6) 10 nm CuPc doped with A3;
7) 80 nm Au;

The initial performance (under AM1.5G) of both devices was without IL: FF=0,35, Voc=0,58 V; and with IL: FF=0,47, Voc=0,54 V. The current density was very similar, about 8 mA/cm².

After aging the encapsulated devices under a halogen lamp (adjusted to obtain the same current density as under AM1.5G) for 1000 h, the FF of the device without IL was 0,32 in contrast to FF= 0,41 of the device with IL. Improvement was also observed in a solar cell where the materials of layer 3 and 5 where exchanged.

Such improvements can also be applied to other device structures, such as p-i-n solar cells, tandem and others.

The features disclosed in this specification, claims and / or the figures may be material for the realization of the invention in its various embodiments, taken in isolation or in various combinations thereof.

## Claims

1. An organic photoactive device, comprising an organic light emitting diode or an organic solar cell provided with a first electrode, a second electrode, and a stack of organic layers provided between the first and second electrodes, the stack of organic layers comprising:
- a first transport layer provided as a layer transporting charge carriers of a first type,
- a second transport layer provided as a layer transporting charge carriers of the first type,
- an interface mediating layer provided in between and contact with the first and second transport layers, and
- a photoactive layer,
wherein the interface mediating layer is made of a first organic material, and at least one of the first and second transport layers comprises a second organic material, the first and second organic materials being selected to form a dopant-host material system for electrical doping, and
wherein one of the following features is provided:
- if the charge carriers of the first type are holes, the energetic HOMO level of the first transport layer (HOMO_1) and the energetic HOMO level of the second transport layer (HOMO_2) are provided as follows:
HOMO_2 - 0.7 eV < HOMO_1 < HOMO_2 + 0.7 eV HOMO_1 ≠ HOMO_2, and
- if the charge carriers of the first type arc electrons, the energetic LUMO level of the first transport layer (LUMO_1) and the energetic LUMO level of the second transport layer (LUMO_2) arc provided as follows:
LUMO_2 - 0.7 eV < LUMO_1 1 < LUMO_2 + 0.7 eV LUMO_1 ≠ LUMO_2.

2. Device according to claim 1, wherein at least one of the first and second transport layers is provided with a layer thickness of at least about 20 nm.

3. Device according to claim 1 or 2, wherein the photoactive layer is provided in the second transport layer or separately from the first and second transport layers.

4. Device according to one of the preceding claims, wherein the interface mediating layer is provided with a layer thickness between about 0.3 nm and about 2 nm.

5. Device according to one of the preceding claims, wherein at least one of the first and second transport layers is provided as an electrically doped transport layer comprising a mixture of the first and second organic material, the first and second organic materials being provided as an electrical dopant material and a matrix material, respectively.

6. Device according to claim 5, wherein one of the following features is provided:
- if the electrically doped transport layer is a hole transport layer, the energetic HOMO level of the matrix material (HOMO_matrix) and the energetic LUMO level of the dopant material (LUMO_dopant) arc provided as follows:
LUMO_dopant < HOMO_matrix + 0.5 cV,
preferably HOMO_matrix - 0.5 cV < LUMO_dopant < HOMO_matrix + 0.5 eV, and
- if the electrically doped transport layer is an electron transport layer, the energetic LUMO level of the matrix material (LUMO_matrix) and the energetic HOMO level of the dopant material(HOMO _dopant) are provided as follows:
LUMO_matrix - 0.5 cV < HOMO_dopant,
preferably LUMO_matrix - 0.5 eV < HOMO_dopant < LUMO_matrix + 0.5 eV.

7. Device according to one of the preceding claims, wherein at least one of the first and second transport layers is provided as an electrically non-doped transport layer.

8. Device according to one of the preceding claims, wherein the photoactive layer is provided with a plurality of photoactive sub-layers.

9. Device according to one of the preceding claims, wherein the first and second transport layers comprise different organic materials.

10. Device according to one of the preceding claims, wherein the photoactive layer comprises a light emitting layer provided in an organic light emitting diode.

11. Device according to claim 10, wherein:
- the second transport layer is closer to the light emitting layer than the first transport layer,
- the charge carriers of the first type are injected from the first transport layer into the second transport layer, and
- one of the following features is provided:
- if the charge carriers of the first type are holes, the energetic HOMO level of the first transport layer (HOMO) and the energetic HOMO level of the second transport layer (HOMO_2) are provided as follows:
HOMO_2 - 0.2 eV < HOMO_1 < IIOMO_2 + 0.5 eV and HOMO_1 ≠ IIOMO_2, and
- if the charge carriers of the first type are electrons, the energetic LUMO level of the first transport layer (LUMO_1) and the energetic LUMO level of the second transport layer (LUMO_2) arc provided as follows:
LUMO_2 - 0.5 eV < LUMO_1 < LUMO_2 + 0.2 eV LUMO_1 ≠ LUMO_2.

12. Device according to claim 11, wherein one of the following features is provided:
- if the charge carriers of the first type are holes, the energetic HOMO level of the first transport layer (HOMO_1) and the energetic HOMO level of the second transport layer (HOMO_2) are provided as follows:
HOMO_1 > HOMO_2 - 0.1 eV, and
- if the charge carriers of the first type are electrons, the energetic LUMO level of the first transport layer (LUMO_1) and the energetic LUMO level of the second transport layer (LUMO_2) are provided as follows:
LUMO_2 - 0.1 eV > LUMO_1.

13. Device according to one of the claims 1 to 9, wherein the photoactive layer comprises a light absorbing layer provided in an organic solar cell.

14. Device according to claim 13, wherein:
- the second transport layer is closer to the light absorbing layer than the first transport layer,
- the charge carriers of the second type are injected from the first transport layer into the first transport layer, and
- one of the following features is provided:
- if the charge carriers of the first type are holes, the energetic HOMO level of the first transport layer (HOMO_1) and the energetic HOMO level of the second transport layer (HOMO_2) are provided as follows:
HOMO_2 - 0.5 eV < HOMO < HOMO_2 + 0.2 eV and HOMO_1 ≠ HOMO_2, and
- if the charge carriers of the first type arc electrons, the energetic LUMO level of the first transport layer (LUMO_1) and the energetic LUMO level of the second transport layer (LUMO2) are provided as follows:
LUMO_2 - 0.5 eV < LUMO_1 < LUMO_2 + 0.2 eV LUMO_1 ≠ LUMO_2.

15. Device according to claim 14, wherein the charge carriers are the photogenerated charge carriers.
